# EUROPEAN PATENT APPLICATION

(11) **EP 4 513 538 A1**
(43) Date of publication of application: **26.02.2025**
(21) Application number: 22938337.7
(22) Date of filing: 19.12.2022
(51) Int. Cl.: H01L 21/687

(54) **WAFER CARRIER DEVICE**

(30) Priority: 20.04.2022 CN 202210415919
(71) Applicant: Jiangsu Leuven Instruments Co., Ltd., Xuzhou, Jiangsu 221300 (CN)
(72) Inventor: SANG, Kang, Xuzhou, Jiangsu 221300 (CN); HU, Dongdong, Xuzhou, Jiangsu 221300 (CN); CHEN, Longbao, Xuzhou, Jiangsu 221300 (CN); LIU, Pengfei, Xuzhou, Jiangsu 221300 (CN); WANG, Chengyi, Xuzhou, Jiangsu 221300 (CN); CHENG, Shiran, Xuzhou, Jiangsu 221300 (CN); GUO, Song, Xuzhou, Jiangsu 221300 (CN); XU, Kaidong, Xuzhou, Jiangsu 221300 (CN)
(74) Representative: Eisenführ Speiser
(86) International application number: PCT/CN2022/139933
(87) International publication number: WO 2023/202119

(57) **Abstract**

A wafer carrier device, comprising: a housing assembly, which is in communication with the atmospheric environment and comprises a supporting plate; a rotating table assembly, which comprises a supporting table and a pressing portion that is configured to press a wafer on the supporting table; a first magnetic fluid shaft, which comprises a first inner shaft and a first outer shaft which are arranged in a rotary seal manner, the first outer shaft being assembled on the supporting plate in a sealing manner, the first inner shaft having a first end portion extending into the housing assembly and a second end portion extending out of the housing assembly, and the second end portion being connected to the rotating table assembly; a lifting assembly, which comprises a main body portion and a lifting body, the main body portion being located in the housing assembly, the lifting body being in sliding seal with the supporting plate or the first outer shaft, and the lifting body being capable of acting with the pressing portion; and a shielding assembly, which comprises a baffle that is configured to be rotatably assembled on the supporting plate so as to switch between a first station facing the rotating table assembly and a second station staggered with the rotating table assembly.

## Description

The present application claims the priority of the Chinese Patent Application No. 202210415919.1, titled "WAFER CARRIER DEVICE", filed on April 20, 2022 with the China National Intellectual Property Administration, which is incorporated herein by reference in its entirety.

### FIELD

The present application relates to the technical field of wafer manufacturing, and in particular to a wafer carrier device.

### BACKGROUND

Ion beam etching and ion beam deposition are two common wafer processing technologies. The ion beam etching is a purely physical process, in which a material surface is bombarded by ions with certain energy to make material atoms sputter, thus achieving a purpose of etching. The ion beam deposition is a vapor deposition method, in which an ion source is used to ionize the material used for deposition, and ions are emitted to a surface of wafer under an action of an electric field to deposit a film layer, with a purpose of changing the surface properties of the workpiece.

In the process, the ion source is usually in a fixed position, and then the processing position is adjusted by rotating the wafer. The whole machining process is in a vacuum environment. For this purpose, in the conventional technology, there is a carrier device for supporting the wafer, which provides a driving force to meet the movement required for processing the wafer.

In the wafer processing, a pressing portion is provided for pressing the wafer. In order to facilitate pressing and removing the wafer, it is necessary to provide a lifting assembly to control the pressing portion to move. However, the lifting assembly used in the existing carrier device is generally a special vacuum component, which is configured and exposed in a vacuum environment as a whole, causing a high cost and inconvenient product maintenance.

### SUMMARY

An object of the present application is to provide a wafer carrier device, which is convenient for assembly and maintenance, has a high degree of integration, can be relatively small in size and occupy less space, and is equipped with a shielding assembly that can achieve the shielding or avoidance of the wafer.

In order to solve the above technical problems, a wafer carrier device is provided according to the present application, which includes a housing assembly in communication with the atmospheric environment, a rotating table assembly, a first hydro-magnetic shaft and a lifting assembly. The housing assembly includes a supporting plate. The rotating table assembly includes a supporting table and a pressing portion used to press the wafer against the supporting table. The first hydro-magnetic shaft includes a first inner shaft and a first outer shaft which are rotationally sealed with each other. The first outer shaft is hermetically assembled on the supporting plate. The first inner shaft has a first end extending into the housing assembly and a second end extending out of the housing assembly, and the second end is connected with the rotating table assembly. The lifting assembly includes a main body portion and a lifting body. The main body portion is located in the housing assembly, and the lifting body is slidably sealed with the supporting plate or the first outer shaft. The lifting body interacts with the pressing portion. The shielding assembly includes a baffle rotatably assembled on the supporting plate so as to switch between a first station facing the rotating table assembly and a second station staggered with the rotating table assembly.

With this solution, the housing assembly may isolate the external vacuum environment from the internal atmospheric environment, and the main body portion of the lifting assembly may be integrally assembled in the housing assembly and thus only need to adopt a conventional component, reducing the cost and facilitating the assembly and maintenance. The first hydro-magnetic shaft includes a first inner shaft and a first outer shaft which are rotationally sealed with each other, and the first outer shaft may be hermetically assembled on the supporting plate so as to cooperate with the housing assembly to isolate the internal environment from external environment. The lifting body may be slidably sealed with the supporting plate or the outer shaft, and the force may be transmitted from the lifting assembly to the pressing portion under the condition of isolating the internal environment from external environment, so as to drive the pressing portion to move relatively close to or away from the supporting table, thereby loading and pressing the wafer conveniently.

Moreover, it is possible for the shielding assembly to shield or keep clear of the rotating table assembly. In the first station for shielding, the baffle may face the rotating table assembly to shield the wafer located on the rotating table assembly, which may effectively prevent the ion beam current from causing damage to the wafer and facilitate prolonging the service life of the supporting table. In the second station for keeping clear, the baffle may be staggered with the rotating table assembly to expose the wafer, thereby processing the wafer conveniently.

Optionally, the rotating table assembly further includes a rotating main body. The rotating main body includes the pressing portion, a force transmission member and a guide rod. The pressing portion and the force transmission member are located at two axial sides of the supporting table respectively. The guide rod is slidably assembled on the supporting table. Both ends of the guide rod are respectively connected with the pressing portion and the force transmission member. The lifting body interacts with the force transmission member.

Optionally, the force transmission member is annular in shape.

Optionally, the wafer carrier device further includes an elastic member. The elastic member is arranged between the supporting table and the force transmission member.

Optionally, the elastic member is a spring mounted outside the guide rod.

Optionally, the supporting table is provided with a guide sleeve, and the guide rod is inserted into the guide sleeve.

Optionally, the guide sleeve is embedded in the supporting table.

Optionally, the force transmission member is further provided with a jacking pin. The jacking pin and the guide rod are located on a same side of the force transmission member, and a size of the jacking pin is smaller than that of the guide rod.

Optionally, the lifting assembly further includes a pushing portion located outside the housing assembly and connected with the lifting body.

Optionally, the pressing portion and the pushing portion are both annular in shape.

Optionally, the main body portion includes a bellows mounted outside the lifting body.

Optionally, the main body portion further includes a pneumatic cylinder and a lifting plate. The pneumatic cylinder is provided with a piston rod connected with the lifting plate, and a plurality of lifting bodies are mounted on the lifting plate.

Optionally, the wafer carrier device further includes a first driving assembly. The first driving assembly is located in the housing assembly and has a first driving shaft which is in transmission connection with the first inner shaft.

Optionally, the first driving shaft and the first inner shaft are arranged in parallel with each other.

Optionally, the wafer carrier device further includes a second hydro-magnetic shaft. The hydro-magnetic shaft includes a second inner shaft and a second outer shaft which are rotationally sealed with each other. The second outer shaft is hermetically assembled on the supporting plate. The second inner shaft has a third end extending into the housing assembly and a fourth end extending out of the housing assembly, and the fourth end is connected with the baffle.

Optionally, the wafer carrier device further includes a second driving assembly. The second driving assembly is located in the housing assembly and has a second driving shaft which is in transmission connection with the third end.

Optionally, the second driving shaft and the second inner shaft are coaxially arranged.

Optionally, the wafer carrier device further includes a connecting portion, and the fourth end part is connected to the baffle through the connecting portion.

Optionally, the housing assembly further includes a first housing and a second housing. The first housing is mounted on the supporting plate and the second housing is mounted on the supporting plate and the second housing.

Optionally, the wafer carrier device further includes a revolving shaft, and the revolving shaft is connected with the second housing.

### BRIEF DESCRIPTION OF THE DRAWINGS

FIG. 1 is a schematic structural view of a specific embodiment of a wafer carrier device provided according to the present application;
FIG. 2 is a schematic structural view of a lifting assembly; and
FIG. 3 is a schematic structural view of a rotating main body.

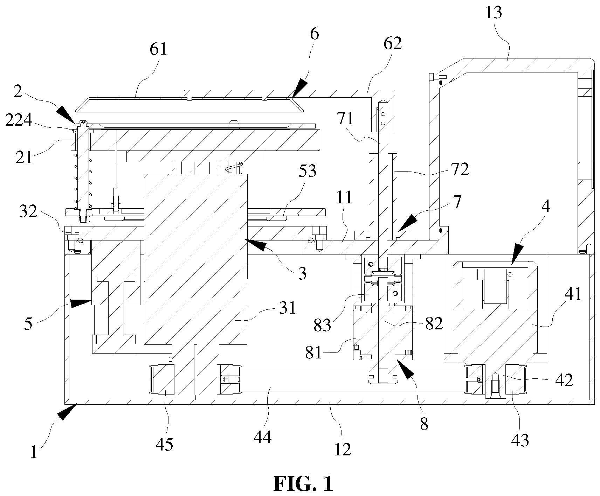

Description of the reference numerals in FIGS. 1 to 3:
1 housing assembly, 11 supporting plate, 12 first housing, 13 second housing;
2 rotating table assembly, 21 supporting table, 22 rotating main body, 221 pressing portion, 222 force transmission member, 223 guide rod, 224 guide sleeve, 225 elastic member, 226 jacking pin;
3 first hydro-magnetic shaft, 31 first inner shaft, 32 first outer shaft;
4 first driving assembly, 41 motor, 42 first driving shaft, 43 driving wheel, 44 driven wheel, 45 synchronous belt;
5 lifting assembly, 51 main body portion, 511 pneumatic cylinder, 512 piston rod, 513 lifting plate, 514 bellows, 52 lifting body, 53 pushing portion;
6 shielding assembly, 61 baffle, 62 connecting portion;
7 second hydro-magnetic shaft, 71 second inner shaft, 72 second outer shaft;
8 second driving assembly, 81 rotary pneumatic cylinder, 82 second driving shaft, 83 coupling.

### DETAILED DESCRIPTION OF THE EMBODIMENTS

In order to enable those skilled in the art to better understand the technical solutions of the present application, the present application will be described in further detail below in conjunction with the accompanying drawings and specific embodiments.

In the specification, the terms "multiple" refers to a plural indefinite number or quantity, usually more than two. When the term "multiple" is used to indicate the number of certain components, it does not mean that these components are quantitatively related to each other.

Herein terms such as "first" and "second" are only intended to distinguish two or more structures or components that have identical or similar structure and/or functions, and do not indicate any special limitation on an order and/or importance.

Magnetic fluid, also known as magnetic liquid or ferrofluid, is a colloidal material composed of solid and liquid phases. The solid phase mainly refers to magnetic solid nanoparticles, and the liquid phase refers to the liquid that can carry the solid magnetic nanoparticles. The magnetic fluid has the fluidity, lubricity and sealing performance of liquid carriers, and also has the strong magnetism and other characteristics of solid nanoparticles.

Hydro-magnetic sealing is to fix the magnetic fluid between an inner shaft and an outer shaft with permanent magnets. Since a gap between the inner shaft and the outer shaft is very small and its magnetic field strength is particularly large, it can bear a large thrust along an axial direction to achieve the sealing effect. The inner shaft, the outer shaft and the magnetic fluid arranged therebetween can be collectively called the hydro-magnetic shaft.

As mentioned in the background, the lifting assembly used in the existing carrier device is generally a special vacuum component, which is configured and exposed in a vacuum environment as a whole, causing a high cost and inconvenient product assembly and maintenance.

In view of this, a wafer carrier device is provided according to an embodiment of the present application, which is provided with a housing assembly to isolate an internal space (atmospheric environment) from an external space (vacuum environment) of the housing assembly. A main body portion of the lifting assembly may be arranged in the housing assembly, that is to say, the lifting assembly may be almost located in the atmospheric environment. In this case, the lifting assembly only needs to adopt a conventional component, with the low cost and the decreased difficulty of assembly and maintenance.

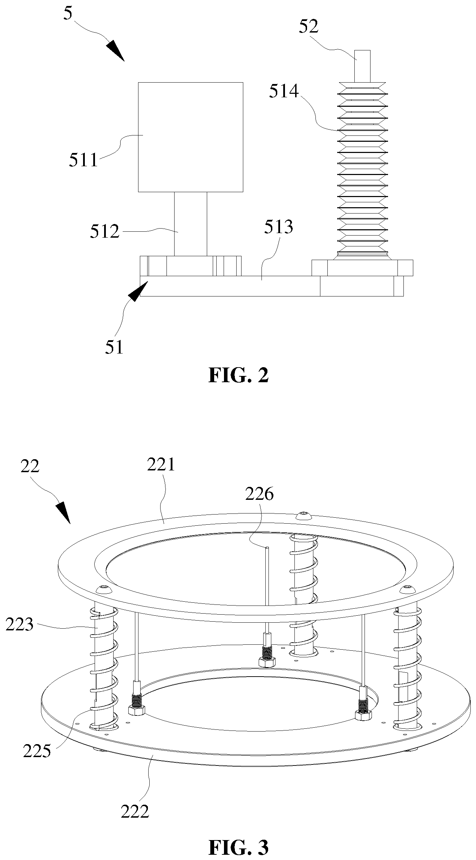

Reference may be made to FIGS. 1 to 3 for details. FIG. 1 is a schematic structural view of a specific embodiment of a wafer carrier device provided according to the present application; FIG. 2 is a schematic structural view of a lifting assembly; and FIG. 3 is a schematic structural view of a rotating main body.

As shown in FIG. 1, a wafer carrier device is provided according to the present application, including a housing assembly 1, a rotating table assembly 2, a first hydro-magnetic shaft 3 and a lifting assembly 5. The internal space of the housing assembly 1 is communicated with the atmospheric environment, that is, the internal space of the housing assembly 1 is regarded as the atmospheric environment. The housing assembly 1 includes a supporting plate 11. The rotating table assembly 2 includes a supporting table 21 and a pressing portion 221. The supporting table 21 is used to support a wafer, and the pressing portion 221 is used to press the wafer against the supporting table 21 to ensure the wafer to be stably fixed. The pressing portion 221 may be a one-piece annular structure or may include multiple split bodies distributed in a circumferential direction. The first hydro-magnetic shaft 3 includes a first inner shaft 31 and a first outer shaft 32, and magnetic fluid (not shown) is arranged between the first inner shaft 31 and the first outer shaft 32 to realize rotary sealing therebetween. The first outer shaft 32 is assembled on the supporting plate 11 in a sealed manner (for example, by providing a sealing ring, a gasket or the like) as a fixed shaft. The first inner shaft 31 has a first end extending into the housing assembly 1 and a second end extending out of the housing assembly 1, and the second end is connected with the rotating table assembly 2. The lifting assembly 5 including a main body portion 51 and a lifting body 52. The main body portion 51 is located in the housing assembly 1. The lifting body 52 is slidably sealed with the supporting plate 11 or the first outer shaft 32 to isolate the internal environment from external environment, and the lifting body 52 may interact with the pressing portion 221 to drive the pressing portion 221 to act.

With this solution, the housing assembly 1 may isolate the external vacuum environment from the internal atmospheric environment, and the main body portion 51 of the lifting assembly 5 may be wholly assembled in the housing assembly 1. In this way, the lifting assembly 5 only needs to adopt a conventional component, thus lowering the cost and facilitating the assembly and maintenance. The first hydro-magnetic shaft 3 includes a first inner shaft 31 and a first outer shaft 32 which are rotationally sealed with each other. The first outer shaft 32 may be assembled on the supporting plate 11 in a sealed manner to cooperate with the housing assembly 1 to isolate the internal environment from external environment. The lifting body 52 may be slidably sealed with the supporting plate 11 or the outer shaft 32, so that a force may be transmitted from the lifting assembly 5 to the pressing portion 221 under the condition of isolating the internal environment from external environment, so as to drive the pressing portion 221 to move relatively close to or away from the supporting table 21, thereby conveniently realizing the loading and fastening of the wafer.

In the above solution, both of the first hydro-magnetic shaft 3 and the lifting assembly 5 are assembled in the housing assembly 1, so the overall integration level may be high and the volume may be small.

Here, the specific structural form of the lifting assembly 5 is not limited by the embodiment of the present application, and in practical application, those skilled in the art can make a choice as required. For example, the lifting assembly 5 may adopt a driving element that can directly output linear displacement, for example, a pneumatic cylinder and a hydraulic cylinder. In this case, the lifting body 52 may be a piston rod of the driving element. Alternatively, the lifting assembly 5 may also use a driving element that can directly output rotational displacement, for example, a motor. In this case, it is necessary to provide a displacement conversion mechanism in the form of a rack-and-pinion mechanism, a lead screw mechanism or the like to convert the directly output rotational displacement into a required linear displacement. Taking the rack-and-pinion mechanism as an example, the lifting body 52 may be a rack.

In the embodiment of FIG. 2, the lifting assembly 5 may adopt a standard pneumatic cylinder, and the main body portion 51 may include a pneumatic cylinder 511 and a lifting plate 513. The pneumatic cylinder 511 has a piston rod 512 which is extendable and retractable to drive the lifting plate 513 to move upwards or downwards. The lifting body 52 described above may be mounted on the lifting plate 513. With this structure, the lifting plate 513 is equivalent to a transition connector, on which multiple lifting bodies 52 may be mounted, and then multi-point driving can be realized by a single pneumatic cylinder 511. Thus, on the one hand, the number of the pneumatic cylinders 511 can be reduced to save costs, and the problem of inconsistent actions caused by using multiple pneumatic cylinders 511 can be avoided. On the other hand, the multi-point driving is more conducive to ensuring the stability of the upward or downward movement of the pressing portion 221.

It should be pointed out that the solution in which the single pneumatic cylinder 511 generates multiple driving points by the transition connection of the lifting plate 513 is only a preferred solution of the embodiment of the present application, but it does not mean that only one pneumatic cylinder 511 can be used in the specific practice. In fact, the number of the pneumatic cylinders 511 may be multiple in order to generate greater driving force.

Further, the main body portion 51 may further include a bellows 514, one end of which may be connected with the lifting plate 513, and the other end of which may be connected with the supporting plate 11 (if the lifting body 52 extends from the first outer shaft 32, the other end of the bellows 514 may also be connected with the first outer shaft 32). The bellows 514 may be mounted outside the lifting body 52 to realize the sealing assembly between the lifting body 52 and the supporting plate 11 (or the first outer shaft 32). The bellows 514 has certain elastic deformation ability. When the pneumatic cylinder 511 is inflated to drive the pressing portion 221 to lift upward, the bellows 514 may be compressed, and when the pneumatic cylinder 511 is deflated, the elastic force of the bellows 514 may be released, which facilitates a quick return of the pressing portion 221. Moreover, the bellows 514 may further be used to limit the stroke of the pneumatic cylinder 511.

It can be understood that the sliding sealing mode is not limited to the bellows 514, but can also be realized by providing an annular seal in the form of a sealing ring or the like.

The lifting body 52 may be directly connected with the pressing portion 221, or the lifting body 52 may be indirectly connected to the pressing portion 221 via other components, depending on the structural form of the rotating table assembly 2.

In the embodiment as shown in FIGS. 1 and 3, the rotating table assembly 2 may further include a rotating main body 22. The rotating main body 22 may include a pressing portion 221, a force transmission member 222 and a guide rod 223. The pressing portion 221 and the force transmission member 222 may be located at both axial sides of the supporting table 21, respectively. The guide rod 223 may be slidably mounted on the supporting table 21, that is, the guide rod 223 may slide relative to the supporting table 21. Both ends of the guide rod 223 may be connected with the pressing portion 221 and the force transmission member 222 respectively, so that the rotating main body 22 and the supporting table 21 may form into an integrated component, and the integration level can be improved. The lifting body 52 may interact with the force transmission member 222.

The supporting table 21 may be provided with a through hole, and the guide rod 223 may be inserted into the through hole to realize the sliding of the guide rod 223 relative to the supporting table 21. Alternatively, the rotating main body 22 may further include a guide sleeve 224, which may be mounted on the supporting table 21, specifically, on an axial side of the supporting table 21 or in the supporting table 21. The guide rod 223 may also be inserted into the guide sleeve 224. The guide sleeve 224 is a special guide fitting member, which has higher guide precision and is more conducive to ensuring the sliding direction of the guide rod 223. It is a preferred solution of the embodiment of the present application.

The pressing portion 221 may press or fix the wafer by its own gravity.

Alternatively, an elastic member 225 may be provided, and the elastic member 225 may be arranged between the supporting table 21 and the force transmission member 222. In this way, when the lifting assembly 5 applies a jacking force to the force transmission member 222 so as to drive the pressing portion 221 to move relatively away from the supporting table 21, the elastic member 225 may be compressed to accumulate elastic force. When the jacking force generated by the lifting assembly 5 disappears, the elastic force accumulated by the elastic member 225 can be released, which can drive the pressing portion 221 to quickly return. Moreover, the elastic member 225 may also improve the reliability in pressing and fixing the wafer by the pressing portion 221.

Here, the embodiment of the present application does not limit the specific structural form of the elastic member 225, and in practical application, those skilled in the art can design it based on actual needs, as long as it can meet the use requirements. For example, the elastic member 225 may be an elastic body made of rubber material with certain elastic properties, or the elastic member 225 may also be a spring, bellows or the like. In the embodiment as shown in FIGS. 1 and 3, the elastic member 225 may be a spring, and the spring may be mounted outside the guide rod 223. In this embodiment, the guide rod 223 may also realize the radial positioning of the spring, so as to avoid the radial movement of the spring in the use process to a great extent and improve the stability of the spring.

Further, the force transmission member 222 may be provided with a jacking pin 226, and the jacking pin 226 and the guide rod 223 may be located at the same side of the force transmission member 222. Moreover, the axial size of the jacking pin 226 may be smaller than that of the guide rod 223, so that the support height of the guide rod 223 is higher than that of the jacking pin 226.

When the force transmission member 222 is driven to drive the guide rod 223 and the jacking pin 226 to lift up, the guide rod 223 may drive the pressing portion 221 to move away from the supporting table 21, before the jacking pin 226 starts to contact with the wafer and drives the wafer away from the supporting table 21. When the force transmission member 222 is driven to drive the guide rod 223 and the jacking pin 226 to descend, the jacking pin 226 may stably place the wafer on the supporting table 21, before the pressing portion 221 presses against the wafer. With this arrangement, the interference between the wafer and the pressing portion 221 during movement can be well avoided.

With reference to FIG. 1, the lifting assembly 5 may further include a pushing portion 53, which may be located outside the housing assembly 1 and connected with the lifting body 52. The lifting body 52 may interact with the force transmission member 222 through the pushing portion 53.

The structure of an abutting portion 227 is not limited as long as it can interact with the force transmission member 222. For example, the abutting portion 227 may be a one-piece annular member. Alternatively, the abutting portion 227 may also have a split structure, and may include multiple sub-parts distributed in the circumferential direction. The number of the sub-parts may be the same as the number of the lifting bodies 52, and the sub-parts may be mounted on the lifting bodies 52 in one-to-one correspondence. Here, the abutting portion 227 refers to the pushing portion 53.

The pushing portion 53 may not only interact with the force transmission member 222, but also limit the stroke of the lifting assembly 5 by abutting against the supporting plate 11 (or the first outer shaft 32).

Further, the wafer carrier device provided by the present application may further include a first driving assembly 4, which may also be located in the housing assembly 1. The first driving assembly 4 may have a first driving shaft 42, which may be in transmission connection with the first inner shaft 31 to drive the first inner shaft 31 to rotate, which may in turn transmit the rotating driving force to the supporting table 21 to drive the wafer to rotate. With this solution, the first driving assembly 4 is also in the atmospheric environment. as a result, the first driving assembly 4 only needs to adopt a conventional component, reducing the cost and facilitating the assembly and maintenance.

The transmission connection between the first driving shaft 42 and the first inner shaft 31 is not limited, as long as the rotational driving force of the first driving shaft 42 can be transmitted to the first inner shaft 31. In some embodiments, the first driving shaft 42 and the first inner shaft 31 may be coaxially arranged, and in this case, they can be connected by means of the coupling or other components. In other embodiments, as shown in FIG. 1, the first driving shaft 42 and the first inner shaft 31 may be parallel to each other. The first driving assembly 4 may be located at a radial side of the first hydro-magnetic shaft 3, which facilitates reducing the axial occupied space of the carrier device. The transmission between the first driving shaft 42 and the first inner shaft 31 includes but is not limited to gear transmission, sprocket transmission and pulley transmission. Taking the pulley transmission as an example, with reference to FIG. 1, a driving wheel 43 may be mounted on the first driving shaft 42, and a driven wheel 45 may be mounted on the first inner shaft 31. A synchronous belt 45 may be mounted on the driving wheel 43 and the driven wheel 44 so as to transfer the driving force of the driving wheel 43 to the driven wheel 44. And, a ratio of transmission between the first driving shaft 42 and the first inner shaft 31 may be adjusted by adjusting the radial size of the driving wheel 43 and the driven wheel 44.

Further, the wafer carrier device may further include a shielding assembly 6, and the shielding assembly 6 may include a baffle 61 rotatably mounted on the supporting plate 11.

The baffle 61 has a first station and a second station. At the first station, the baffle 61 may face the rotating table assembly 2 to shield the wafer located on the rotating table assembly 2, which can effectively prevent the wafer from being damaged by the ion beam and facilitate prolonging the service life of the supporting table 21. At the second station, the baffle 61 may be staggered with the rotating table assembly 2 to expose the wafer, so that the wafer can be processed conveniently.

The action of the baffle 61 can be controlled manually, that is, the operator can manually drive the baffle 61 to rotate and switch between the first station and the second station. Thus, the structure of the device can be relatively simple.

Alternatively, a special driving structure may be provided to automatically drive the baffle 61 to rotate and switch between the first station and the second station. Thus, the automation degree of the device can be higher. In this embodiment, the wafer carrier device provided by the present application may further include a second hydro-magnetic shaft 7 and a second driving assembly 8. The second hydro-magnetic shaft 7 is similar in structure to the first hydro-magnetic shaft 3. The second hydro-magnetic shaft 7 may include a second inner shaft 71 and a second outer shaft 72, which may be rotatably sealed with each other by providing magnetic fluid. The second outer shaft 72 may be hermetically assembled on the supporting plate 11 as a fixed shaft, and the second inner shaft 71 has a third end extending into the housing assembly 1 and a fourth end extending out of the housing assembly 1. The fourth end and the baffle 61 may be connected with each other. The fourth end and the baffle 61 may be directly connected with each other, or a connecting portion 62 may be arranged on the baffle 61 and may be connected with the fourth end. The second driving assembly 8 may be located in the housing assembly 1. The second driving assembly 8 may have a second driving shaft 82, and the second driving shaft 82 may be in transmission connection with the third end, so as to drive the baffle 61 to rotate through the third end.

With this solution, the second driving assembly 8 is also arranged in the atmospheric environment, and the second driving assembly 8 only needs to adopt a conventional component, thereby reducing the cost and facilitating the assembly and maintenance of products. The second hydro-magnetic shaft 7 may isolate the internal environment from external environment and transmit the driving force of the second driving assembly 8 to the shielding assembly 6.

Here, the embodiment of the present application does not limit the structural form of the second driving assembly 8, and in specific practice, those skilled in the art may design it based on actual needs, as long as it can meet the use requirements. For example, the second driving assembly 8 may use a motor, a rotary pneumatic cylinder, etc. as a driving element. Taking the rotary pneumatic cylinder as an example, with reference to FIG. 1, the second driving assembly 8 may include a rotary pneumatic cylinder 81, which may have a second driving shaft 82. The second driving shaft 82 may be in transmission connection with the second inner shaft 71. In this regard, reference may be made to the description of the first driving shaft 42 and the first inner shaft 31. In the drawing, the transmission is realized by providing a coupling 83, and the rotary pneumatic cylinder 81 may realize the reciprocating rotation of the baffle 61 within a predetermined angular range.

Similarly, the embodiment of the present application does not limit the structural form of the housing assembly 1, as long as corresponding technical effects can be achieved. In the embodiment shown in FIG. 1, the housing assembly 1 may include a supporting plate 11, a first housing 12 and a second housing 13, and the second housing 13 may be provided with a notch for communicating with the external environment. Moreover, the second housing 13 may also be connected with a revolving shaft (not shown), and in specific applications, the wafer carrier device can be driven to rotate wholly by the revolving shaft, so as to adjust the orientation of the supporting table 21.

The above descriptions are merely preferred embodiments of the present application. It should be noted that various improvements and modifications can be made by those skilled in the art without departing from the principles of the present application. These improvements and modifications should fall within the protection scope of the present application.

## Claims

1. A wafer carrier device, comprising:
a housing assembly (1) communicated with atmospheric environment and comprising a supporting plate (11);
a rotating table assembly (2) comprising a supporting table (21) and a pressing portion (221), wherein the pressing portion (221) is configured to press a wafer against the supporting table (21);
a first hydro-magnetic shaft (3) comprising a first inner shaft (31) and a first outer shaft (32) rotationally sealed with each other, wherein the first outer shaft (32) is hermetically assembled on the supporting plate (11), and the first inner shaft (31) has a first end extending into the housing assembly (1) and a second end extending out of the housing assembly (1), and the second end is connected with the rotating table assembly (2);
a lifting assembly (5) comprising a main body portion (51) and a lifting body (52), wherein the main body portion (51) is located in the housing assembly (1), and the lifting body (52) is slidably sealed with the supporting plate (11) or the first outer shaft (32), and the lifting body (52) is adapted to interact with the pressing portion (221); and
a shielding assembly (6) comprising a baffle (61), wherein the baffle (61) is rotatably assembled on the supporting plate (11) so as to switch between a first station facing the rotating table assembly (2) and a second station staggered with the rotating table assembly (2).

2. The wafer carrier device according to claim 1, wherein the rotating table assembly (2) further comprises a rotating main body (22), and the rotating main body (22) comprises the pressing portion (221), a force transmission member (222) and a guide rod (223), wherein the pressing portion (221) and the force transmission member (222) are located at opposite axial sides of the supporting table (21) respectively, and wherein the guide rod (223) is slidably assembled on the supporting table (21), both ends of the guide rod (223) are respectively connected with the pressing portion (221) and the force transmission member (222), and the lifting body (52) is adapted to interact with the force transmission member (222).

3. The wafer carrier device according to claim 2, wherein the force transmission member (222) is annular in shape.

4. The wafer carrier device according to claim 2, further comprising an elastic member (225) arranged between the supporting table (21) and the force transmission member (222).

5. The wafer carrier device according to claim 4, wherein the elastic member (225) is a spring, which is mounted outside the guide rod (223).

6. The wafer carrier device according to claim 2, wherein the supporting table (21) is provided with a guide sleeve (224), and the guide rod (223) is inserted into the guide sleeve (224).

7. The wafer carrier device according to claim 6, wherein the guide sleeve (224) is embedded in the supporting table (21).

8. The wafer carrier device according to claim 2, wherein the force transmission member (222) is further provided with a jacking pin (226), and wherein the jacking pin (226) and the guide rod (223) are located on a same side of the force transmission member (222), and a size of the jacking pin (226) is smaller than that of the guide rod (223).

9. The wafer carrier device according to claim 2, wherein the lifting assembly (5) further comprises a pushing portion (53) located outside the housing assembly (1) and connected with the lifting body (52).

10. The wafer carrier device according to claim 9, wherein the pressing portion (221) and the pushing portion (53) are both annular in shape.

11. The wafer carrier device according to any one of claims 1 to 10, wherein the main body portion (51) comprises a bellows (514) mounted outside the lifting body (52).

12. The wafer carrier device according to any one of claims 1 to 10, wherein the main body portion (51) further comprises a pneumatic cylinder (511) and a lifting plate (513), and wherein the pneumatic cylinder (511) has a piston rod (512) connected with the lifting plate (513), and a plurality of lifting bodies (52) are mounted on the lifting plate (513).

13. The wafer carrier device according to any one of claims 1 to 10, further comprising a first driving assembly (4) located in the housing assembly (1), wherein the first driving assembly (4) has a first driving shaft (42) which is in transmission connection with the first inner shaft (31).

14. The wafer carrier device according to claim 13, wherein the first driving shaft (42) and the first inner shaft (31) are arranged in parallel with each other.

15. The wafer carrier device according to any one of claims 1 to 10, further comprising a second hydro-magnetic shaft (7), wherein the second hydro-magnetic shaft comprises a second inner shaft (71) and a second outer shaft (72) rotationally sealed with each other, the second outer shaft (72) is hermetically assembled on the supporting plate (11), and the second inner shaft (72) has a third end extending into the housing assembly (1) and a fourth end extending out of the housing assembly (1), and the fourth end is connected to the baffle (61).

16. The wafer carrier device according to claim 15, further comprising a second driving assembly (8), wherein the second driving assembly (8) is located in the housing assembly (1) and has a second driving shaft (82) which is in transmission connection with the third end.

17. The wafer carrier device according to claim 16, wherein the second driving shaft (82) and the second inner shaft (71) are coaxially arranged.

18. The wafer carrier device according to claim 16, further comprising a connecting portion (62), wherein the fourth end is connected to the baffle (61) through the connecting portion (62).

19. The wafer carrier device according to any one of claims 1 to 10, wherein the housing assembly (1) further comprises a first housing (12) and a second housing (13), and wherein the first housing (12) is mounted on the supporting plate (11), and the second housing (13) is mounted on the supporting plate (11) and the second housing (13).

20. The wafer carrier device according to claim 19, further comprising a revolving shaft, wherein the revolving shaft is connected with the second housing (13).
